Europäisches Patentamt

European Patent Office

Office européen des brevets

(19)

(11) Numéro de publication: **0 106 728
B1**

(12)                    **FASCICULE DE BREVET EUROPEEN**

(45) Date de publication du fascicule du brevet:
**07.01.88**

(51) Int. Cl.⁴: **H 01 L 31/10, H 01 L 31/02**

(21) Numéro de dépôt: **83401763.4**

(22) Date de dépôt: **07.09.83**

(54) **Procédé et dispositif de stabilisation du gain d'un élément photosensible à avalanche.**

(30) Priorité: **14.09.82 FR 8215479**

(43) Date de publication de la demande:
**25.04.84 Bulletin 84/17**

(45) Mention de la délivrance du brevet:
**07.01.88 Bulletin 88/1**

(84) Etats contractants désignés:
**DE GB IT**

(56) Documents cités:
**DE - A - 2 257 181
FR - A - 2 080 029
FR - A - 2 346 697
FR - A - 2 490 404**

(73) Titulaire: **SOCIETE ANONYME DE
TELECOMMUNICATIONS, 41, rue Cantagrel,
F-75624 Paris Cedex 13 (FR)**

(72) Inventeur: **Beaudet, Didier, 41, rue Cantagrel,
F-75624 Paris Cedex 13 (FR)**
Inventeur: **Nicole, Pierre, 41, rue Cantgrel, F-75624 Paris
Cedex 13 (FR)**

(74) Mandataire: **Martinet & Lapoux, 62, rue des Mathurins,
F-75008 Paris (FR)**

## Description

La présente invention concerne la réalisation de récepteurs optiques recevant des signaux par voie optique telle qu'une fibre optique. Plus particulièrement, l'invention a trait à la stabilisation de gain d'un élément photosensible à avalanche tel qu'une photodiode à avalanche.

Les photodiodes à avalanche assurent, par exemple, la photodétection de signaux lumineux transmis par fibre optique. Elles sont employées, le plus souvent, du fait de leur rapport signal sur bruit élevé lié à un gain important. Le gain d'une photodiode à avalanche est fonction de la tension inverse de polarisation dite tension d'avalanche.

Toutefois les photodiodes à avalanche présentent des courbes caractéristiques peu stables. En particulier pour une puissance optique reçue donnée, le courant photodétecté varie avec la température. D'autres causes d'instabilité peuvent également provenir de surcharges accidentelles ou du vieillissement.

Des procédés de stabilisation du gain d'une photodiode à avalanche ont déjà été décrits.

Un procédé connu consiste à placer la photodiode dans une enceinte thermostatée. La stabilisation obtenue est cependant imparfaite car elle ne tient pas compte de la différence de température qui peut exister entre la zone active de la photodiode et son boîtier. L'énergie thermique dégagée par la photodiode par le passage du courant au niveau de la zone active n'est en effet pas négligeable.

Un autre procédé connu consiste à ajuster le gain de la photodiode par une correction de la tension de polarisation qui est appliquée à la photodiode.

Selon le DE-A-2 257 181, pour compenser les variations de gain de la photodiode exposée aux signaux optiques en fonction de la température, est prévue une autre photodiode à avalanche reliée en parallèle avec une combinaison d'une résistance et de la photodiode exposée, et alimentée par une source de tension. Ladite autre photodiode n'est pas soumise à des signaux optiques et est polarisée de sorte qu'elle offre une variation de tension de polarisation en fonction de la température aussi proche que possible que celle de la photodiode exposée.

La présente invention vise à corriger le gain d'un élément photosensible à avalanche grâce à une combinaison de composants électroniques aisément sélectionnables et/ou réglables afin d'obtenir une stabilité optimale du gain intrinsèque de l'élément photosensible.

A cette fin, le dispositif de stabilisation du gain d'un élément photosensible d'avalanche selon l'invention est tel que défini dans la revendication 1.

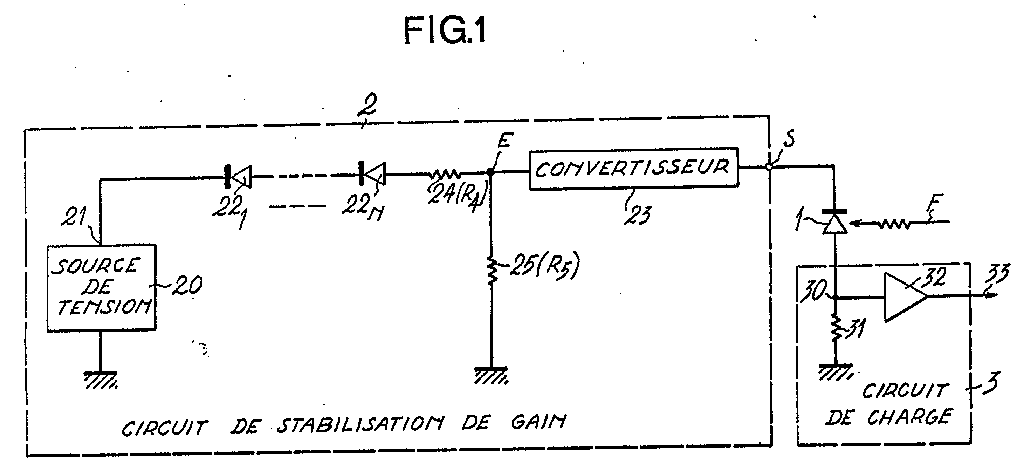

D'autres avantages et caractéristiques de l'invention apparaîtront plus clairement à la lecture de la description suivante d'une réalisation préférée du dispositif de stabilisation de gain selon l'invention en référence à la figure unique annexée.

En se référant à la figure, la photodiode 1 est polarisée en inverse pour fonctionner en régime d'avalanche. La cathode de la photodiode 1 est reliée à la sortie S d'un circuit de stabilisation de gain 2 selon l'invention. L'anode de la photodiode 1 est reliée à l'entrée 30 d'un circuit de charge 3.

Le circuit de stabilisation de gain 2 comprend une source à basse tension 20 qui est stabilisée en température par exemple à l'aide d'une diode de Zener. La borne positive 21 de la source de tension 20 fournit une basse tension de polarisation $V_0$ stabilisée en température, de 10 à 20 Volts. Dans le circuit 2, la borne 21 est reliée à N diodes classiques $22_1$ à $22_N$ connectées en série et polarisées en inverse. La tension aux bornes de chaque diode $22_1$ à $22_N$ est désignée par $V_D$.

Le circuit de stabilisation de gain 2 comprend également un convertisseur de tension continu-continu 23, dit également convertisseur basse tension – haute tension. L'entrée E du convertisseur 23 est reliée à l'anode de la diode $22_N$ à travers une résistance 24, ainsi qu'à une borne référée à la terre à travers une résistance d'entrée 25. Les valeurs résistives $R_4$ et $R_5$ des résistances 24 et 25 ainsi que le nombre N de diodes $22_1$ à $22_N$ sont déterminées en fonction des relations mentionnées dans la suite. Le gain G du convertisseur 23 est égal au rapport $V_S/V_E$, où $V_S$ désigne la tension de sortie à la borne S confondue avec la sortie du convertisseur 23, et $V_E$ désigne la tension d'entrée du convertisseur à la borne E. Ainsi $V_S$ désigne la tension de polarisation de la photodiode à avalanche 1 à stabiliser en température. La tension $V_S$ est élevée typiquement de l'ordre de 100 à 200 Volts ce qui justifie la présence du convertisseur de tension 23.

Le circuit de charge 3 selon la réalisation illustrée est classique. Il comprend une résistance 31 entre la borne 30 et une borne référée à la terre, et un amplificateur à haute impédance 32 entre la borne 30 et une borne de sortie 33. Selon une autre réalisation non représentée, le circuit de charge peut être utilisé en transimpédance et être constitué par un amplificateur ayant un gain négatif, connecté à une boucle de contre-réaction contenant une résistance de charge pour la mesure du photocourant. Dans les deux réalisations, la tension mesurée aux bornes de la résistance de charge telle que 30 est proportionnelle au photocourant transmis par la photodiode 1 lorsque la photodiode 1 est éclairée par un faisceau lumineux F.

La tension de polarisation $V_S$ de la photodiode à avalanche 1 est donnée par la relation suivante:

$$V_S = \frac{GR_5}{(R_4+R_5)} (V_0-NV_D) \qquad (1)$$

déduite des relations:

$$V_S = GV_E$$

$$V_E = \frac{R_5}{(R_4+R_5)} (V_0 - NV_D)$$

Puisque la source de tension 20 est stabilisée en température, il apparaît que la tension $V_E$ ne dépend que de la tension $V_D$ créée aux bornes de chaque diode $22_1$ à $22_N$. Comme il est connu, la tension $V_D$ varie proportionnellement à la température selon la relation:

$$V_D = \frac{kT}{q} \cdot \log\left(\frac{I}{I_{sat}} + 1\right)$$

où k est la constante de Boltzmann, T est la température absolue, q est la charge de l'électron, I est le courant traversant la diode $22_1$ à $22_N$, et $I_{sat}$ est le courant de saturation de la diode.

Soit $\alpha_D = (\Delta V_D/\Delta T)$, le cœfficient négatif de variation de la tension $V_D$ aux bornes de chaque diode $22_1$ à $22_N$ en fonction de la température, et soit $\alpha_S = (\Delta V_S/\Delta T)$ le cœfficient positif de variation de la tension $V_S$ en fonction de la température. Pour obtenir un gain intrinsèque constant de la photodiode 1 indépendamment de la température, il apparaît que la variation de la tension de polarisation de la photodiode doit évoluer en fonction de la variation de la tension aux bornes des diodes $22_1$ à $22_N$ d'après la relation (1). $\alpha_D$, $R_5$, G et $\alpha_S$ étant des paramètres donnés par le fabricant des diodes, du convertisseur et de la photodiode, on peut déduire la valeur résistive $R_4$ de la résistance 24 en dérivant la relation (1), d'où il résulte la relation:

$$(\Delta V_S/\Delta T) = -\frac{NG\ R_5}{(R_4 + R_5)}(\Delta V_D/\Delta T)$$

soit $R_4 = -R_5(1 + NG\ \alpha_D/\alpha_S)$.     (2)

La relation (2) est valable tant que le gain G du convertisseur 23 demeure constant. A cet égard, on choisit un convertisseur 23 à tension stabilisée en température.

Par exemple, pour $\alpha_S = 0,4$ V/°K, $\alpha_D = -2,25$ mV/°K, G = 100, $R_5 = 20$ kΩ et N = 3, la relation (2) donne $R_4 = 13,75$ kΩ.

Ainsi, le choix des valeurs des composants du circuit de stabilisation 2 et l'insertion des diodes $22_1$ à $22_N$ dans le circuit 2 permettent de compenser parfaitement le gain de la photodiode à avalanche en présence de variations de température.

Selon une autre variante, le convertisseur 2 est un convertisseur de tension à gain ajustable G afin d'ajuster la valeur de gain G pour une valeur $R_4$ donnée en fonction de la relation (2). En particulier, lorsque la valeur résistive $R_4$ de la résistance 24 est choisie égale à zéro, la gain G représente, d'après la relation (1), le gain de conversion de tension par rapport à un moyen d'alimentation de tension composé par la source 20 et les diodes $22_1$ à $22_N$.

Bien que le mode de réalisation décrit ait trait à une photodiode à avalanche, le dispositif de stabilisation peut être utilisé pour tout autre élément photosensible à avalanche, tel qu'un phototransistor à avalanche.

## Revendications

1. Dispositif de stabilisation du gain d'un élément photosensible à avalanche (1), dans lequel une variation de gain de l'élément photosensible en fonction de la température est compensée en appliquant à l'élément photosensible une tension de polarisation ($V_S$) ayant une variation en fonction de la température ($\Delta V_S/\Delta T$) ajustée sur le cœfficient de température ($\alpha_S$) de l'élément photosensible, caractérisé en ce qu'il comprend une source de tension (20) stabilisée en température, des moyens de conversion de tension (23, 24, 25) ayant une sortie (S) produisant ladite tension de polarisation ($V_S$), et au moins une diode ($22_1$ à $22_N$) polarisée en inverse et fonctionnant avec un cœfficient de température négatif ($\alpha_D$), ladite diode étant connectée en série entre la source de tension (20) et l'entrée des moyens de conversion de tension (23, 24, 25).

2. Dispositif conforme à la revendication 1, caractérisé en ce que les moyens de conversion de tension comprennent un convertisseur de tension continu-continu (23) ayant une entrée (E) reliée à la diode ($22_1$ à $22_N$) et à une résistance (25) reliée à une borne référée à la terre.

3. Dispositif conforme à la revendication 2, caractérisé en ce que les moyens de conversion de tension comprennent une résistance (24) entre l'entrée (E) du convertisseur de tension (23) et la diode ($22_1$ à $22_N$).

4. Dispositif conforme à la revendication 3 ou 4, caractérisé en ce que le gain (G) du convertisseur de tension (23) est ajustable.

## Claims

1. Device for stabilizing gain of a photosensitive avalanche member (1), in which a variation in gain of the photosensitive member depending on temperature is compensated for by applying to the photosensitive member a biasing voltage ($V_s$) having a variation in terms of temperature ($\Delta V_s/\Delta T$) adjusted on the temperature coefficient ($\alpha_S$) of the photosentive member, characterized in that it comprises a temperature-stabilized voltage source (20), voltage converting means (23, 24, 25) having an output (S) delivering said biasing voltage ($V_S$), and at least a reverse-biased diode ($22_1$ to $22_N$) operating with a negative temperature coefficient ($\alpha_D$), said diode being connected in series between the voltage source (20) and the input of the voltage converting means (23, 24, 25).

2. Device according to claim 1, characterized in that the voltage converting means comprise a dc-dc voltage converter (23) having an input (E) connected to the diode ($22_1$ to $22_N$) and to a resistor (25) connected to a grounded terminal.

3. Device according to claim 2, characterized in that the voltage converting means comprise a resistor (24) between the input (E) of the voltage converter (23) and the diode ($22_1$ to $22_N$).

4. Device according to claim 3 or 4, characterized in that the gain (G) of the voltage converter (23) is adjustable.

## Patentansprüche

1. Vorrichtung zur Stabilisierung der Verstärkung eines fotoempfindlichen Avalanche-Elements (1), in der eine Verstärkungsänderung des fotoempfindlichen Elements in Abhängigkeit von der Temperatur kompensiert wird, indem an das fotoempfindliche Element eine Polarisationsspannung ($V_S$) angelegt wird, die eine auf den Temperaturkoeffizienten ($\alpha_S$) des fotoempfindlichen Elements eingestellte Änderung als Funktion der Temperatur ($\Delta V_S/\Delta T$) besitzt, dadurch gekennzeichnet, dass sie eine temperaturstabilisierte Spannungsquelle (20), Mittel zur Spannungsumwandlung (23, 24, 25), die einen die Polarisationsspannung ($V_S$) erzeugenden Ausgang (S) besitzen, und mindestens eine Diode ($22_1$ bis $22_N$) besitzen, die umgekehrt polarisiert ist und mit einem negativen Temperaturkoeffizienten ($\alpha_D$) arbeitet, wobei die Diode in Reihe zwischen der Spannungsquelle (20) und dem Eingang der Mittel zur Spannungsumwandlung (23, 24, 25) angeschlossen ist.

2. Vorrichtung nach Anspruch 1, dadurch gekennzeichnet, dass die Mittel zur Spannungsumwandlung einen Gleichspannung -Gleichspannung-Umwandler (23) umfassen, der einen mit der Diode ($22_1$ bis $22_N$) verbundenen Eingang (E) und einen Widerstand (25) aufweist, der mit einem auf die Erde bezogenen Anschluss verbunden ist.

3. Vorrichtung nach Anspruch 2, dadurch gekennzeichnet, dass die Mittel zur Spannungsumwandlung einen Widerstand (24) zwischen dem Eingang (E) des Spannungsumwandlers (23) und der Diode ($22_1$ bis $22_N$) aufweisen.

4. Vorrichtung nach Anspruch 3 oder 4, dadurch gekennzeichnet, dass die Verstärkung (G) des Spannungsumwandlers (23) einstellbar ist.

# FIG.1

CIRCUIT DE STABILISATION DE GAIN

SOURCE DE TENSION — 20

CONVERTISSEUR — 23

$24(R_4)$

$25(R_5)$

$22_1$ — — — $22_M$

21

E

S

CIRCUIT DE CHARGE — 3

30

31

32

33

F

1

0 106 728